# EUROPEAN PATENT APPLICATION

(11) **EP 4 549 958 A1**
(43) Date of publication of application: **07.05.2025**
(21) Application number: 24164518.3
(22) Date of filing: 19.03.2024
(51) Int. Cl.: G01R 1/20, G01R 19/165, G01R 31/382, H01M 10/48

(54) **BATTERY PACK AND CURRENT SENSOR DIAGNOSIS METHOD**

(30) Priority: 31.10.2023 KR 20230148107
(71) Applicant: Samsung SDI Co., Ltd., Yongin-si, Gyeonggi-do 17084 (KR)
(72) Inventor: KIM, Pyung Kap, 16678 Suwon-si (KR)
(74) Representative: Marks & Clerk LLP

(57) **Abstract**

Disclosed are a battery pack and a current sensor diagnosis method that enable diagnosis of an abnormality of a current sensor including a shunt resistor. The battery pack includes: a battery module comprising a plurality of battery cells; a current sensor measuring a current in the battery module; a first switch connected to a current path between a cathode (B+) and a first pack terminal (P+) of the battery module; a second switch connected to a current path between an anode (B-) and a second pack terminal (P-) of the battery module; first to third temperature sensors measuring a shunt temperature of the current sensor, a first switch temperature of the first switch, and a second switch temperature of the second switch, respectively; and a processor diagnosing the current sensor based on at least one of the shunt temperature, the first switch temperature, and the second switch temperature.

## Description

### BACKGROUND

### 1. Field

The present invention relates to a battery pack and a current sensor diagnosis method that enable diagnosis of an abnormality of a current sensor including a shunt resistor.

### 2. Description of the Related Art

With rapidly increasing demand for portable electronic products, such as laptops, video cameras, and mobile phones, and the development of electric vehicles, energy storage batteries, robots, satellites, and the like, active research has been carried out on development of high-performance secondary batteries (hereafter referred to as batteries) that can be repeatedly charged and discharged.

In general, a power supply system of a battery may be provided with a current sensor to measure current. The current sensor measures the current flowing along a charge/discharge path of the battery to monitor the state of the battery, and to detect overcurrent in the battery, and the like. The current measured by the current sensor can be utilized as information to calculate the SOC (state of charge) of the battery or as a basis for determining whether a charging/discharging process is normally carried out, and the like.

A shunt resistor may be used as a component for measurement of a current flowing through a battery and the current may be measured by measuring a voltage across the shunt resistor. However, if the shunt resistor does not operate normally, the current flowing through the battery cannot be measured properly. As a result, even in the event of an abnormal situation, such as overcurrent and the like, the shunt resistor cannot block the overcurrent properly, thereby causing serious problems, such as battery failure or explosion.

This section is intended only to provide a better understanding of the background of the invention and thus may include information which is not necessarily prior art.

### Summary

It is an aspect of the present invention to provide a battery pack and a current sensor diagnosis method that enables diagnosis of an abnormality of a current sensor including a shunt resistor.

According to the present invention there is provided a battery pack comprising:
a battery module comprising a plurality of battery cells;
a current sensor configured to measure a current in the battery module;
a first switch connected to a first current path between a cathode of the battery module and a first pack terminal;
a second switch connected to a second current path between an anode of the battery module and a second pack terminal;
first to third temperature sensors configured to measure a shunt temperature of the current sensor, a first switch temperature of the first switch, and a second switch temperature of the second switch, respectively; and
a processor configured to diagnose the current sensor based on at least one of the shunt temperature, the first switch temperature, and the second switch temperature.

The present invention also provides a current sensor diagnosis method comprising:
calculating, by a processor, an average of current accumulated to date, followed by obtaining a shunt saturation temperature, a first switch saturation temperature, and a second switch saturation temperature corresponding to the calculated average current;
calculating, by the processor, a shunt temperature difference meaning an absolute value of a difference between a shunt temperature measured by a first temperature sensor and the shunt saturation temperature, a first switch temperature difference meaning an absolute value of a difference between a first switch temperature measured by a second temperature sensor and the first switch saturation temperature, and a second switch temperature difference meaning an absolute value of a difference between a second switch temperature measured by a third temperature sensor and the second switch saturation temperature; and
diagnosing, by the processor, an abnormality of a current sensor by comparing the shunt temperature difference, the first switch temperature difference, and the second switch temperature difference with a reference value.

The present invention also provides a current sensor diagnosis method comprising:
receiving, by a processor, at least one of a shunt temperature measured by a first temperature sensor, a first switch temperature measured by a second temperature sensor, and a second switch temperature measured by a third temperature sensor; and
diagnosing, by the processor, an abnormality of a current sensor by comparing at least one of the shunt temperature, the first switch temperature, and the second switch temperature with at least one of a preset shunt maximum temperature, a first switch maximum temperature, and a second switch maximum temperature.

The above and other aspects and features of the present invention will become apparent from the following description of embodiments of the present invention.

In accordance with an aspect of the present invention, a battery pack diagnoses a current sensor based on at least one of a shunt temperature measured at a shunt resistor, a first switch temperature measured at a first switch, and a second switch temperature measured at a second switch.

According to the present invention, the battery pack and the current sensor diagnosis method can detect abnormality (failure, defect) of a shunt resistor, thereby enabling accurate detection of overcurrent through diagnosis of abnormality of a current sensor including a shunt resistor.

According to the present invention, the battery pack and the current sensor diagnosis method can reduce or prevent problems, such as battery failure and explosion due to abnormalities (errors, failure) of the shunt resistor.

According to the present invention, the battery pack and the current sensor diagnosis method can detect abnormality (failure, defect) of the shunt resistor and can reduce a risk caused by abnormality of the shunt resistor by changing abnormality of the shunt resistor from a single point fault to a dual point fault.

However, aspects and features of the present invention are not limited to the above and other aspects and features not mentioned will be clearly understood by those skilled in the art from the detailed description given below.

At least some of the above and other features of the invention are set out in the claims.

Further features of the present invention may include:
the processor determining that shunt resistance value decrease failure has occurred when a difference between the shunt temperature and the average temperature is negative, a difference between the first switch temperature and the average temperature is positive, and a difference between the second switch temperature and the average temperature is positive;
   and/or
the processor determining that shunt resistance value increase failure has occurred when a difference between the shunt temperature and the average temperature is positive, a difference between the first switch temperature and the average temperature is negative, and a difference between the second switch temperature and the average temperature is negative;
   and/or
upon determining that the current sensor is abnormal, the processor is configured to determine a type of the abnormality of the current sensor based on a sign of the difference between the shunt temperature and the shunt saturation temperature;
   and/or
the processor is configured to determine that a shunt resistance value decrease failure has occurred when the difference between the shunt temperature and the shunt saturation temperature is negative, and to determine that a shunt resistance value increase failure has occurred when the difference between the shunt temperature and the shunt saturation temperature is positive.

### Brief Description of the Drawings

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a block diagram of a battery pack;
FIG. 2 is a circuit diagram of the battery pack;
FIG. 3 is a flowchart illustrating a current sensor diagnosis method according to one embodiment of the present invention; and
FIG. 4 is a flowchart illustrating a current sensor diagnosis method according to another embodiment of the present invention.

### Detailed Description

Hereinafter, embodiments of the present disclosure will be described, in detail, with reference to the accompanying drawings. The terms or words used in this specification and claims should not be construed as being limited to the usual or dictionary meaning and should be interpreted with a meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of' and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Electronic or electric devices and/or any other relevant devices or components according to embodiments of the present disclosure described herein may be implemented utilizing any suitable hardware, firmware (e.g., an application-specific integrated circuit), software, or a combination of software, firmware, and hardware, to process data or digital signals. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Circuit hardware may include, for example, application specific integrated circuits (ASICs), general purpose or special purpose central processing units (CPUs) that is configured to execute instructions stored in a non-transitory storage medium, digital signal processors (DSPs), graphics processing units (GPUs), and programmable logic devices such as field programmable gate arrays (FPGAs).

Further, the various components of these devices may be a process or thread, running on one or more processors, in one or more computing devices, executing computer program instructions and interacting with other system components for performing the various functionalities described herein. The computer program instructions are stored in a memory that may be implemented in a computing device using a standard memory device, such as, for example, a random-access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

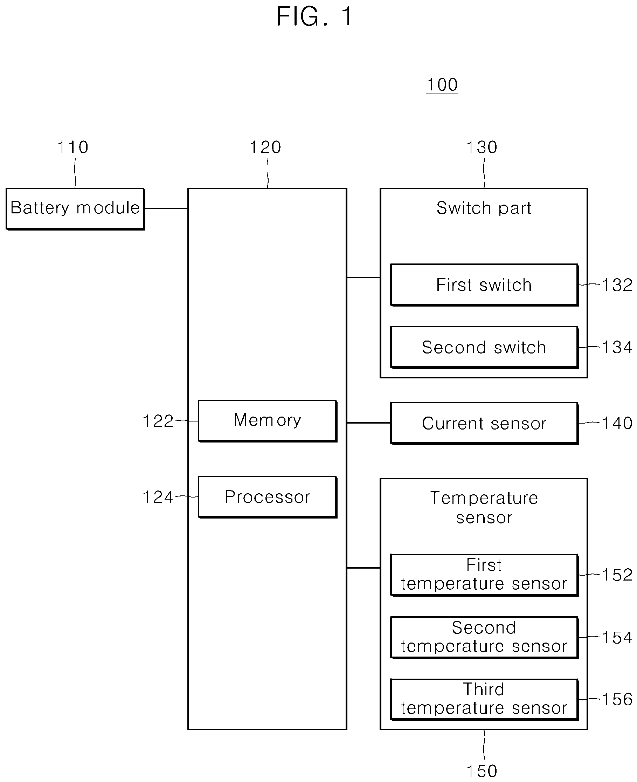

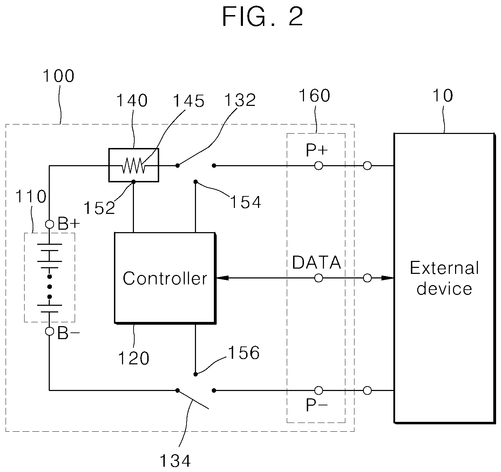

FIG. 1 is a block diagram of a battery pack and FIG. 2 is a circuit diagram of the battery pack.

Referring to FIG. 1 and FIG. 2, a battery pack 100 according to one embodiment of the present invention has a structure that can be electrically connected to an external device 10 through a cathode connection terminal P(+) and an anode connection terminal P(-). When the external device 10 is a load, the battery pack 100 is discharged by acting as a power source to provide power to the load. The external device 10 operating as a load may be, for example, an electronic device, a mobile vehicle, or an energy storage system (ESS). Here, the mobile vehicle may be, for example, an electric vehicle, a hybrid vehicle, or a smart mobility device.

The battery pack 100 may include at least one battery module 110, a controller 120, a switch part 130, a current sensor 140, a temperature sensor 150, and an interface 160. In various embodiments, obviously, the battery pack 100 may further include other components.

The battery module 110 may include a plurality of battery cells and a module housing. The battery module 110 may include a plurality of cells connected to each other in series or parallel. Such battery modules 110 may be connected to each other in series or parallel.

The battery cells may be stacked and received in the module housing. The battery cells may include cathode leads and anode leads. The battery cells may be round, prismatic, or pouch type battery cells depending on the shape of the battery.

The battery pack 100 may include a single stack of cells stacked to form a single module instead of the battery modules. The cell stack may be received in an accommodation space of the pack housing, or in an accommodation space partitioned by a frame, a partition wall, or the like.

The battery cell may generate a large amount of heat during charging/discharging. The generated heat may be accumulated in the battery cell, promoting degradation of the battery cell. Accordingly, the battery pack 100 may further include a cooling member to inhibit degradation of the battery cell. The cooling member may be disposed at a lower portion of the accommodation space which receives the battery cells. Alternatively, the cooling member may be disposed at an upper portion or a side surface thereof depending on the battery pack 100.

Exhaust gas generated inside the battery cell due to an abnormal operating condition, also known as thermal runaway or thermal events in the battery cell, may be discharged from the battery cell. The battery pack 100 or the battery module 110 may include an exhaust vent or the like for discharging the exhaust gas to suppress damage to the battery pack 100 or module due to the exhaust gas.

The interface 160 may include a plurality of terminals for interfacing with the external device 10. The interface 160 may include pack terminals P+, P- for supplying electrical energy to an external load or receiving electrical energy from an external charging device, and a communication terminal DATA for communication with the external device 10.

The interface 160 is connected to the battery module 110 and may act as a terminal for charging the battery module 110 through connection to a charging device (not shown) upon charging. The interface 160 may act as a terminal connected to an external load (not shown) to discharge the battery module 110 upon discharging. To this end, the interface 160 may include a first pack terminal P+ and a second pack terminal P-. The first pack terminal P+ may be a cathode pack terminal connected to a cathode B+ of the battery module 110. The second pack terminal P- may be an anode pack terminal connected to an anode B- of the battery module 110. Charging from the charging device to the battery module 110 may occur when a charging device is connected to the interface 160, and discharging from the battery module 110 to the external load may occur when an external load is connected to the interface 160.

The switch part 130 may be controlled by a processor 124 to control electrical connection between the battery module 110 and the external device 10. The switch part 130 may include a first switch 132 connected between the cathode B+ of the battery module 110 and the first pack terminal P+, and a second switch 134 connected between the anode B- of the battery module 110 and the second pack terminal P-.

The switch part 130 may be connected between the battery module 110 and at least one of the pack terminals P+, P- to cut off/allow electrical connection between the battery module 110 and the external device 10.

When the first switch 132 and the second switch 134 are turned on, power may be supplied from the battery module 110 to the external device 10 or from the external device 10 to the battery module 110.

The first switch 132 and the second switch 134 may be disposed in a power line provided as a current path for charging and discharging the battery module 110.

The first switch 132 and the second switch 134 may be implemented by any one or a combination of two or more of well-known switching devices, such as relays, transistors, and the like.

The current sensor 140 may measure a current of the battery module 110. Here, the current sensor 140 may be a shunt type current sensor 140. The current sensor 140 may measure a current flow between the battery module 110 and the pack terminals P+, P- to obtain the current of the battery module 110, that is, a charging current or a discharging current.

The current sensor 140 may include a shunt resistor 145. Thus, the current sensor 140 can measure the current flowing through the shunt resistor 145. The current sensor 140 including the shunt resistor 145 can calculate a current value flowing along a charge/discharge path of the battery module 110 by measuring a voltage value across the shunt resistor 145. That is, since resistance of the shunt resistor 145 is a known value, the current sensor 140 can calculate a current value flowing in the shunt resistor 145 when the voltage value across the shunt resistor 145 is obtained. Here, the calculated current value can be a current value flowing along the charge/discharge path of the battery module 110.

The shunt resistor 145 is a current-sensing resistor and may be connected in series to a large current path to measure the current (charging current or discharging current) flowing through the large current path.

The shunt resistor 145 may be connected to the large current path between the cathode B+ of the battery module 110 and the first pack terminal P+. However, the present invention is not limited thereto and according to other embodiments, the shunt resistor 145 may be connected to the large current path between the anode B- of the battery module 110 and the second pack terminal P-.

The temperature sensor 150 may measure a shunt temperature of the current sensor 140, a first switch temperature of the first switch 132, and a second switch temperature of the second switch 134. Accordingly, the temperature sensor 150 may include a first temperature sensor 152 provided to the shunt resistor 145, a second temperature sensor 154 provided to the first switch 132, and a third temperature sensor 156 provided to the second switch 134.

The first temperature sensor 152 may measure the temperature of the shunt resistor 145 and may transmit the measured shunt temperature to the processor 124.

The second temperature sensor 154 may measure the temperature of the first switch 132 and may transmit the measured first switch temperature to the processor 124.

The third temperature sensor 156 may measure the temperature of the second switch 134 and may transmit the measured second switch temperature to the processor 124.

Such temperature sensors 150, 152, 154, 156 may be thermocouples, as one example used for temperature measurement.

The controller 120 may include a memory 122 and the processor 124. The controller 120 may be included in a battery management system (BMS).

The memory 122 may store programs (applications) used by the processor 124 to diagnose the current sensor 140. In some embodiments, the memory 122 may store instructions used to operate the processor 124. In some embodiments, the memory 122 may be built into the processor 124 or connected to the processor 124 via a bus. In some embodiments, the memory 122 storing tables may be non-volatile memory.

The processor 124 may control an On/Off status of the first switch 132 and the second switch 134 that connect the battery module 110 to the external device 10. For example, the processor 124 may turn off or on the first switch 132 and the second switch 134 to block or allow the flow of current supplied to the battery module 110 through the large current path from the external charging device. That is, the processor 124 may turn on the first switch 132 and the second switch 134 to allow charging or discharging of the battery module 110. Additionally, the processor 124 may alternatively turn off the first switch 132 and the second switch 134 to block the flow of current through the large current path between the battery module 110 and the external device 10.

When current flows between the battery module 110 and the external device 10, the current sensor 140 may measure the current flowing between the battery module 110 and the external device 10.

Further, the processor 124 may diagnose an abnormality of the current sensor 140 based on at least one of the shunt temperature measured by the first temperature sensor 152, the first switch temperature measured by the second temperature sensor 154, and the second switch temperature measured by the third temperature sensor 156.

As the resistance value of the shunt resistor 145 increases, more energy is consumed for the same current flow. More energy consumption can indicate that more heat is generated when the resistance value of the shunt resistor 145 is large than when the resistance value of the shunt resistor 145 is small. Furthermore, when the shunt resistor 145 is in a normal condition and maintains a constant resistance value, the temperatures measured at the shunt resistor 145, the first switch 132 and the second switch 134 may be similar, since the current flowing in the first switch 132 and the second switch 134 is constant. However, when there is a problem with the shunt resistor 145, the temperatures measured at the first switch 132 and the second switch 134 do not change, whereas the temperature measured at the shunt resistor 145 can change (that is, the temperature measured at the shunt resistor 145 can become larger or smaller). Therefore, when the temperature values at the first switch 132 and the second switch 134 remain unchanged and only the temperature value at the shunt resistor 145 changes significantly, it can be determined that the resistance value of the shunt resistor 145 has changed rather than that the current value has changed.

Accordingly, the processor 124 may determine whether the shunt resistor 145 is abnormal based on the shunt temperature, the first switch temperature, and the second switch temperature. Since the shunt resistor 145 is included in the current sensor 140, abnormality of the shunt resistor 145 may indicate abnormality of the current sensor 140. Thus, abnormality of the shunt resistor 145 may be indicative of abnormality of the current sensor 140.

Thus, the processor 124 may diagnose abnormality of the current sensor 140 based on at least one of the shunt temperature, the first switch temperature, and the second switch temperature.

Next, a method of diagnosing abnormality of the current sensor 140 by the processor 124 will be described.

The processor 124 may diagnose abnormality of the current sensor 140 by comparing at least one of the shunt temperature measured by the first temperature sensor 152, the first switch temperature measured by the second temperature sensor 154, and the second switch temperature measured by the third temperature sensor 156 with at least one of a preset shunt maximum temperature, a first switch maximum temperature, and a second switch maximum temperature. Here, the shunt maximum temperature may be a temperature that saturates at the shunt resistor 145 at a maximum current (e.g., 550 A), the first switch maximum temperature may be a temperature that saturates at the first switch 132 at the maximum current (e.g., 550 A), and the second switch temperature may be a temperature that saturates at the second switch 134 at the maximum current (e.g., 550 A).

Since the current changes, the temperatures measured at the shunt resistor 145, the first switch 132, and the second switch 134 will not exceed the corresponding maximum temperatures measured at the maximum current under a constant resistance condition. Accordingly, the processor 124 may use the shunt maximum temperature, the first switch maximum temperature, and the second switch maximum temperature to determine whether the current sensor 140 is abnormal.

Specifically, when the shunt temperature is less than or equal to the shunt maximum temperature, the first switch temperature is less than or equal to the first switch maximum temperature, and the second switch temperature is less than or equal to the second switch maximum temperature, the processor 124 may determine that the current sensor 140 is normal.

When the shunt temperature exceeds the shunt maximum temperature, the first switch temperature is less than or equal to the first switch maximum temperature, and the second switch temperature is less than or equal to the second switch maximum temperature, the processor 124 may determine that the current sensor 140 is abnormal. When the temperature trends of the first switch and the second switch 134 are similar and only the temperature trend measured at the shunt resistor 145 is different therefrom, it can be seen that there is a problem with the shunt resistor 145. Accordingly, when the shunt temperature exceeds the shunt maximum temperature, the first switch temperature is less than or equal to the first switch maximum temperature, and the second switch temperature is less than or equal to the second switch maximum temperature, the processor 124 may determine that the current sensor 140 is abnormal.

Upon determining that the current sensor 140 is abnormal, the processor 124 may calculate an average temperature of the shunt temperature, the first switch temperature and the second switch temperature, and may compare the calculated average temperature with the shunt temperature, the first switch temperature and the second switch temperature to determine the type of abnormality of the current sensor 140. Here, the type of abnormality of the current sensor 140 may include shunt resistance value decrease failure, shunt resistance value increase failure, and the like.

Specifically, when a difference between the shunt temperature and the average temperature is negative, a difference between the first switch temperature and the average temperature is positive, and a difference between the second switch temperature and the average temperature is positive, the processor 124 may determine that shunt resistance value decrease failure has occurred.

When the resistance value of the shunt resistor 145 decreases, a safety issue can occur since the current must be high in order for a desired voltage value to be measured. For example, when 550A or more is set as an overcurrent, the processor 124 must turn off the first switch 132 and the second switch 134 to cut off the current when the current measured through the shunt resistor 145 is 550 A or more. However, as the resistance value of the shunt resistor decreases, the processor 124 may turn off the first switch 132 and the second switch 134 to cut off the current when the current is in the range of 570 A to 580 A. In this case, the processor 124 fails to detect the overcurrent (overcurrent detection failure), thereby causing a safety issue.

When the difference between the shunt temperature and the average temperature is positive, the difference between the first switch temperature and the average temperature is negative, and the difference between the second switch temperature and the average temperature is negative, the processor 124 may determine that shunt resistance value increase failure has occurred.

When the resistance value of the shunt resistor 145 increases, a quality issue can occur since the current must be lowered in order for a desired voltage value to be measured. For example, when 550 A or more is set as an overcurrent, the processor 124 must turn off the first switch 132 and the second switch 134 to cut off the current when the current measured through the shunt resistor 145 is 550 A or more. However, as the resistance value of the shunt resistor increases, the processor 124 may turn off the first switch 132 and the second switch 134 to cut off the current when the current is in the range of 530 A to 540 A. In this case, a quality issue can occur, despite no occurrence of a safety issue.

According to another embodiment of the present invention, the processor 124 may diagnose abnormality of the current sensor 140 based on a shunt temperature difference, which means an absolute value of a difference between the shunt temperature and a shunt saturation temperature, a first switch temperature difference, which means an absolute value of a difference between the first switch temperature and a first switch saturation temperature, and a second switch temperature difference, which means an absolute value of the difference between the second switch temperature and a second switch saturation temperature. To this end, the memory 122 may store a lookup table in which at least one of the shunt saturation temperature, the first switch saturation temperature, and the second switch saturation temperature depending upon the current is set. The shunt saturation temperature may mean a temperature saturated in the shunt resistor 145 at each current, the first switch saturation temperature may mean a temperature saturated in the first switch 132 at each current, and the second switch saturation temperature may mean a temperature saturated in the second switch at each current.

Next, a method of diagnosing abnormality of the current sensor 140 by the processor 124 using the shunt temperature difference, the first switch temperature difference and the second switch temperature difference will be described.

The processor 124 may calculate an average value of current accumulated to date and obtain, from the lookup table, the shunt saturation temperature, the first switch saturation temperature, and the second switch saturation temperature corresponding to the calculated average current.

Then, the processor 124 may calculate the shunt temperature difference, which means the absolute value of the difference between the shunt temperature and the shunt saturation temperature, the first switch temperature difference, which means the absolute value of the difference between the first switch temperature and the first switch saturation temperature, and the second switch temperature difference, which means the absolute value of the difference between the second switch temperature and the second switch saturation temperature.

Then, the processor 124 may compare the shunt temperature difference, the first switch temperature difference, and the second switch temperature difference with a preset reference value to diagnose abnormality of the current sensor 140. In this case, the reference value may mean (2x the error rate of the temperature sensor 150). The error rate of the temperature sensor 150 may be a preset value.

Specifically, when the shunt temperature difference is less than or equal to the reference value, the first switch temperature difference is less than or equal to the reference value, and the second switch temperature difference is less than or equal to the reference value, the processor 124 may determine that the current sensor 140 is normal.

When the shunt temperature difference exceeds the reference value, the first switch temperature difference is less than or equal to the reference value, and the second switch temperature difference is less than or equal to the reference value, the processor 124 may determine that the current sensor 140 is abnormal.

Upon determining that the current sensor 140 is abnormal, the processor 124 may determine the type of abnormality of the current sensor 140 based on the sign of the difference between the shunt temperature and the shunt saturation temperature.

That is, when the difference between the shunt temperature and the shunt saturation temperature is negative, the processor 124 may determine that shunt resistance value decrease failure has occurred. Upon determining that shunt resistance value decrease failure occurs, a safety issue can occur.

When the difference between the shunt temperature and the shunt saturation temperature is positive, the processor 124 may determine that shunt resistance value increase failure has occurred. Upon determining that the shunt resistance value increase failure occurs, a quality issue can occur, despite no occurrence of a safety issue.

Upon determining that the current sensor 140 is abnormal, the processor 124 may turn off the first switch 132 and the second switch 134 to cut off the current.

The processor 124 may be realized by a central processing unit (CPU) or system on chip (SoC), and may run an operating system or an application to control a plurality of hardware or software components connected to the processor 124, and it may perform various data processing and computations. The processor 124 may be configured to execute at least one instruction stored in the memory 122 and store data resulting from the execution in the memory 122.

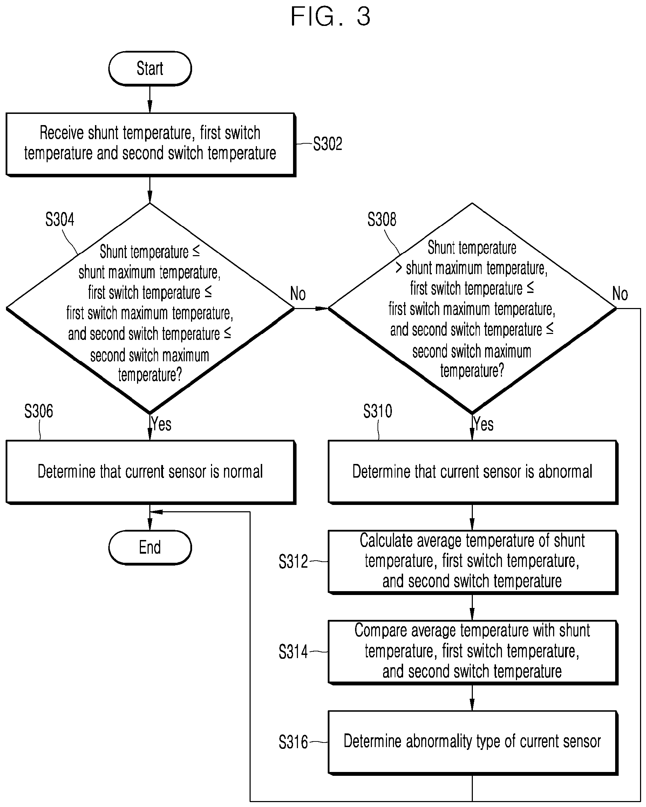

FIG. 3 is a flowchart illustrating a current sensor diagnosis method according to one embodiment of the present invention.

Referring to FIG. 3, the processor 124 receives a shunt temperature, a first switch temperature, and a second switch temperature sent from the first temperature sensor 152, the second temperature sensor 154, and the third temperature sensor 156, respectively (S302). The first temperature sensor 152 provided to the shunt resistor 145 may measure and transmit the shunt temperature to the processor 124. The second temperature sensor 154 provided to the first switch 132 may measure and transmit the first switch temperature to the processor 124. The third temperature sensor 156 provided to the second switch 134 may measure and transmit the second switch temperature to the processor 124.

After step S302, the processor 124 determines whether the shunt temperature is less than or equal to the shunt maximum temperature, the first switch temperature is less than or equal to the first switch maximum temperature, and the second switch temperature is less than or equal to the second switch maximum temperature (S304).

Upon determining in step S304 that the shunt temperature is less than or equal to the shunt maximum temperature, the first switch temperature is less than or equal to the first switch maximum temperature, and the second switch temperature is less than or equal to the second switch maximum temperature, the processor 124 determines that the current sensor 140 is normal (S306).

When it is not determined in step S304 that the shunt temperature is less than or equal to the shunt maximum temperature, the first switch temperature is less than or equal to the first switch maximum temperature, and the second switch temperature is less than or equal to the second switch maximum temperature, the processor 124 determines whether the shunt temperature exceeds the shunt maximum temperature, the first switch temperature is less than or equal to the first switch maximum temperature, and the second switch temperature is less than or equal to the second switch maximum temperature (S308).

Upon determining in step S308 that the shunt temperature exceeds the shunt maximum temperature, the first switch temperature is less than or equal to the first switch maximum temperature, and the second switch temperature is less than or equal to the second switch maximum temperature, the processor 124 determines that the current sensor 140 is abnormal (S310).

Upon determining that the current sensor 140 is abnormal, the processor 124 calculates an average temperature of the shunt temperature, the first switch temperature, and the second switch temperature (S312).

After step S312, the processor 124 compares the calculated average temperature with the shunt temperature, the first switch temperature, and the second switch temperature (S314) to determine the type of abnormality of the current sensor 140 (S316). If the difference between the shunt temperature and the average temperature is negative, the difference between the first switch temperature and the average temperature is positive, and the difference between the second switch temperature and the average temperature is positive, the processor 124 may determine that shunt resistance value decrease failure has occurred. If the difference between the shunt temperature and the average temperature is positive, the difference between the first switch temperature and the average temperature is negative, and the difference between the second switch temperature and the average temperature is negative, the processor 124 may determine that shunt resistance value increase failure has occurred.

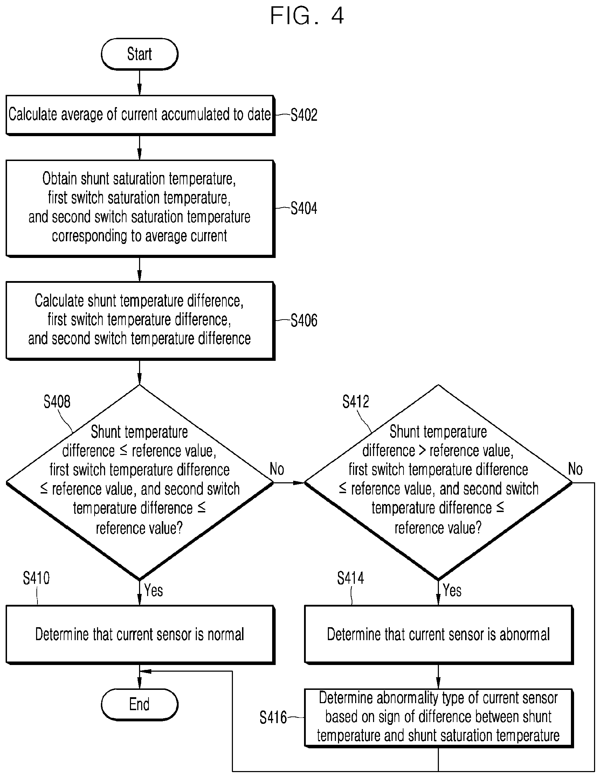

FIG. 4 is a flowchart illustrating a current sensor diagnosis method according to another embodiment of the present invention.

Referring to FIG. 4, the processor 124 calculates an average value of the current accumulated to date (S402) and obtains, from the lookup table, a shunt saturation temperature, a first switch saturation temperature, and a second switch saturation temperature corresponding to the calculated average current (S404). Since the lookup table has the shunt saturation temperature, the first switch saturation temperature, and the second switch saturation temperature set according to the current, the processor 124 may obtain the shunt saturation current, the first switch saturation temperature, and the second switch saturation temperature corresponding to the average current from the lookup table.

After step S404, the processor 124 calculates a shunt temperature difference, a first switch temperature difference, and a second switch temperature difference (S406). Here, the shunt temperature difference may mean an absolute value of a difference between the shunt temperature and the shunt saturation temperature, the first switch temperature difference may mean an absolute value of a difference between the first switch temperature and the first switch saturation temperature, and the second switch temperature difference may mean an absolute value of a difference between the second switch temperature and the second switch saturation temperature.

After step S406, the processor 124 determines whether the shunt temperature difference is less than or equal to a reference value, the first switch temperature difference is less than or equal to the reference value, and the second switch temperature difference is less than or equal to the reference value (S408).

Upon determining in step S408 that the shunt temperature difference is less than or equal to the reference value, the first switch temperature difference is less than or equal to the reference value, and the second switch temperature difference is less than or equal to the reference value, the processor 124 determines that the current sensor 140 is normal (S410).

If step S408 is not satisfied, the processor 124 determines whether the shunt temperature difference exceeds the reference value, the first switch temperature difference is less than or equal to the reference value, and the second switch temperature difference is less than or equal to the reference value (S412).

Upon determining in step S412 that the shunt temperature difference exceeds the reference value, the first switch temperature difference is less than or equal to the reference value, and the second switch temperature difference is less than or equal to the reference value, the processor 124 determines that the current sensor 140 is abnormal (S414).

Upon determining that the current sensor 140 is abnormal, the processor 124 determines the type of abnormality of the current sensor 140 based on the sign of the difference between the shunt temperature and the shunt saturation temperature (S416). In this case, if the difference between the shunt temperature and the shunt saturation temperature is negative, the processor 124 may determine that shunt resistance value decrease failure has occurred. If the difference between the shunt temperature and the shunt saturation temperature is positive, the processor 124 may determine that shunt resistance value increase failure has occurred.

As described above, according to the present invention, the battery pack and the current sensor diagnosis method can detect abnormality (errors, failure) of the shunt resistor, thereby enabling accurate detection of overcurrent through diagnosis of abnormality of the current sensor 140 including the shunt resistor.

According to the present invention, the battery pack and the current sensor diagnosis method can prevent problems, such as battery failure and explosion due to abnormality (errors, failure) of the shunt resistor.

According to the present invention, the battery pack and the current sensor diagnosis method can detect abnormality (errors, failure) of a shunt resistor and can reduce a risk caused by abnormality of the shunt resistor by changing abnormality of the shunt resistor from a single point fault to a dual point fault.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present invention has been described with reference to some embodiments and drawings illustrating aspects thereof, the present invention is not limited thereto. Various modifications and variations can be made by a person skilled in the art to which the present invention belongs within the scope of the invention as set out in the appended claims.

## Claims

1. A battery pack comprising:
a battery module comprising a plurality of battery cells;
a current sensor configured to measure a current in the battery module;
a first switch connected to a first current path between a cathode (B+) of the battery module and a first pack terminal (P+);
a second switch connected to a second current path between an anode (B-) of the battery module and a second pack terminal (P-);
first to third temperature sensors configured to measure a shunt temperature of the current sensor, a first switch temperature of the first switch, and a second switch temperature of the second switch, respectively; and
a processor configured to diagnose the current sensor based on at least one of the shunt temperature, the first switch temperature, and the second switch temperature.

2. The battery pack according to claim 1, wherein the current sensor comprises a shunt resistor and the first temperature sensor is configured to measure a shunt temperature indicative of a temperature of the shunt resistor.

3. The battery pack according to claim 1 or claim 2, wherein the processor is configured to diagnose an abnormality of the current sensor by comparing at least one of the shunt temperature, the first switch temperature, and the second switch temperature with at least one of a preset shunt maximum temperature, a first switch maximum temperature, and a second switch maximum temperature.

4. The battery pack according to claim 3, wherein the processor is configured to determine that the current sensor is normal when the shunt temperature is less than or equal to the shunt maximum temperature, the first switch temperature is less than or equal to the first switch maximum temperature, and the second switch temperature is less than or equal to the second switch maximum temperature.

5. The battery pack according to claim 3 or claim 4, wherein the processor is configured to determine that the current sensor is abnormal when the shunt temperature exceeds the shunt maximum temperature, the first switch temperature is less than or equal to the first switch maximum temperature, and the second switch temperature is less than or equal to the second switch maximum temperature.

6. The battery pack according to claim 5, wherein, upon determining that the current sensor is abnormal, the processor is configured to calculate an average temperature of the shunt temperature, the first switch temperature and the second switch temperature, and to compare the calculated average temperature with the shunt temperature, the first switch temperature and the second switch temperature to determine a type of the abnormality of the current sensor.

7. The battery pack according to any one of the preceding claims, further comprising:
a lookup table in which at least one of a shunt saturation temperature, a first switch saturation temperature, and a second switch saturation temperature depending on current is set,
wherein the processor is configured to calculate an average of current accumulated to date; to obtain a shunt saturation temperature, a first switch saturation temperature, and a second switch saturation temperature corresponding to the calculated average current from the lookup table; to calculate a shunt temperature difference meaning an absolute value of a difference between the shunt temperature and the shunt saturation temperature, a first switch temperature difference meaning an absolute value of a difference between the first switch temperature and the first switch saturation temperature, and a second switch temperature difference meaning an absolute value of a difference between the second switch temperature and the second switch saturation temperature; and to compare the shunt temperature difference, the first switch temperature difference, and the second switch temperature difference with a preset reference value to diagnose abnormality of the current sensor.

8. The battery pack according to claim 7, wherein the processor is configured to determine that the current sensor is normal, when the shunt temperature difference is less than or equal to the reference value, the first switch temperature difference is less than or equal to the reference value, and the second switch temperature difference is less than or equal to the reference value.

9. The battery pack according to claim 7 or claim 8, wherein the processor is configured to determine that the current sensor is abnormal, when the shunt temperature difference exceeds the reference value, the first switch temperature difference is less than or equal to the reference value, and the second switch temperature difference is less than or equal to the reference value.

10. A current sensor diagnosis method comprising:
calculating, by a processor, an average of current accumulated to date, followed by obtaining a shunt saturation temperature, a first switch saturation temperature, and a second switch saturation temperature corresponding to the calculated average current;
calculating, by the processor, a shunt temperature difference meaning an absolute value of a difference between a shunt temperature measured by a first temperature sensor and the shunt saturation temperature, a first switch temperature difference meaning an absolute value of a difference between a first switch temperature measured by a second temperature sensor and the first switch saturation temperature, and a second switch temperature difference meaning an absolute value of a difference between a second switch temperature measured by a third temperature sensor and the second switch saturation temperature; and
diagnosing, by the processor, an abnormality of a current sensor by comparing the shunt temperature difference, the first switch temperature difference, and the second switch temperature difference with a reference value.

11. The current sensor diagnosis method according to claim 10, wherein, diagnosing the abnormality of the current sensor comprises the processor determining that the current sensor is normal, when the shunt temperature difference is less than or equal to the reference value, the first switch temperature difference is less than or equal to the reference value, and the second switch temperature difference is less than or equal to the reference value.

12. The current sensor diagnosis method according to claim 10 or claim 11, wherein, diagnosing the abnormality of the current sensor comprises the processor determining that the current sensor is abnormal, when the shunt temperature difference exceeds the reference value, the first switch temperature difference is less than or equal to the reference value, and the second switch temperature difference is less than or equal to the reference value.

13. A current sensor diagnosis method comprising:
receiving, by a processor, at least one of a shunt temperature measured by a first temperature sensor, a first switch temperature measured by a second temperature sensor, and a second switch temperature measured by a third temperature sensor; and
diagnosing, by the processor, an abnormality of a current sensor by comparing at least one of the shunt temperature, the first switch temperature, and the second switch temperature with at least one of a preset shunt maximum temperature, a first switch maximum temperature, and a second switch maximum temperature.

14. The current sensor diagnosis method according to claim 13, wherein, diagnosing the abnormality of the current sensor comprises the processor determining that the current sensor is normal, when the shunt temperature difference is less than or equal to the reference value, the first switch temperature difference is less than or equal to the reference value, and the second switch temperature difference is less than or equal to the reference value.

15. The current sensor diagnosis method according to claim 13 or claim 14, wherein, diagnosing the abnormality of the current sensor comprises the processor determining that the current sensor is abnormal, when the shunt temperature difference exceeds the reference value, the first switch temperature difference is less than or equal to the reference value, and the second switch temperature difference is less than or equal to the reference value.
